# EUROPEAN PATENT SPECIFICATION

(11) **EP 3 297 074 B1**
(45) Date of publication and mention of the grant of the patent: **22.04.2020**
(21) Application number: 15891916.7
(22) Date of filing: 13.05.2015
(51) Int. Cl.: H01M 14/00, H01M 4/62, H01M 4/139, H01M 4/13, H01G 11/22, H01L 31/042, H01M 10/0583

(54) **THREE-DIMENSIONAL MESH STRUCTURE FORM ELECTRODE FOR ELECTROCHEMICAL DEVICE, METHOD FOR PRODUCING SAME, AND ELECTROCHEMICAL DEVICE COMPRISING SAME**
ELEKTRODE MIT DREIDIMENSIONALER MASCHENSTRUKTUR FÜR ELEKTROCHEMISCHE VORRICHTUNG, VERFAHREN ZUR HERSTELLUNG DAVON UND ELEKTROCHEMISCHE VORRICHTUNG DAMIT
ÉLECTRODE DE FORMATION DE STRUCTURE MAILLÉE EN TROIS DIMENSIONS POUR DISPOSITIF ÉLECTROCHIMIQUE, SON PROCÉDÉ DE PRODUCTION ET DISPOSITIF ÉLECTROCHIMIQUE COMPRENANT CELLE-CI

(43) Date of publication of application: 21.03.2018
(73) Proprietor: Korea Forest Research Institute, Seoul 130-712 (KR)
(72) Inventor: LEE, Sun Young, Seoul 122-813 (KR); LEE, Sang Young, Busan 612-790 (KR); CHUN, Sang Jin, Namyangju-si Gyeonggi-do 472-785 (KR); CHO, Sung Ju, Cheorwon-gun Gangwon-do 269-823 (KR); PARK, Sang Bum, Seoul 133-795 (KR); CHOI, Don Ha, Seoul 135-877 (KR); CHOI, Keun Ho, Gangneung-si Gangwon-do 210-861 (KR); KIM, Jung Hwan, Ulju-gun Ulsan 689-798 (KR)
(74) Representative: Eisenführ Speiser
(86) International application number: PCT/KR2015/004812
(87) International publication number: WO 2016/182100

(56) References cited:
- JP-A- 2002 260 663
- JP-A- 2002 260 663
- KR-A- 20090 027 049
- KR-A- 20090 027 049
- KR-A- 20090 078 656
- US-A1- 2009 269 677
- JABBOUR, L. ET AL.: 'Use of paper-making techniques for the production of Li-ion paper-batteries' NORDIC PULP AND PAPER vol. 27, no. 2, 2012, pages 47 - 475, XP055436331

## Description

### [Technical Field]

The present invention relates to an electrode for an electrochemical device having a three-dimensional network structure form, a method of producing the electrode, and an electrochemical device including the electrode.

### [Background Art]

Recently, the importance of flexible electrochemical devices such as flexible lithium-ion batteries available in various designs such as roll-up displays, wearable electronic devices and the like has been increasing. In order to realize such a flexible electrochemical device, development of a flexible material forming the electrochemical device is required.

For example, the lithium ion secondary battery is produced by sequentially stacking a positive electrode, a separator and a negative electrode in a molded case, and then injecting an electrolyte thereinto. However, the battery having the above-described structure has many limitations in meeting the demand for design diversity required in flexible electrochemical devices due to the lack of physical flexibility.

Particularly, among the components of the lithium ion secondary battery, an electrode such as a positive electrode or a negative electrode is produced by applying an electrode mixture, which is prepared by dispersing active materials in a mixture of a particle-shaped conductive material, a binder and a solvent, on a current collector. Here, the binder is an essential element for increasing the adhesion between the components forming the electrode. However, the binder acts as a cause of a decrease in electron conductivity and energy density of the electrode, an expensive process and a decrease in productivity. Therefore, research for reducing the amount of binder is essential for the next generation secondary battery.

Further, a conventional method of producing an electrode is performed by applying an electrode mixture on a metal current collector. However, the electrode produced by this method has a problem in that an electrode layer is separated from a metal current collector when bending occurs.

JP 2002 260663 A discloses a secondary battery provided with a positive electrode, a negative electrode, and a nonaqueous electrolyte, wherein that at least either one of the positive or the negative electrode contains cellulose fiber, and a part of the cellulose fiber has 0.01-50 µm thickness and the ratio of its length L to the thickness T (L/T) is set to 5 or more.

US 2009/0269677 A discloses a secondary battery comprising a cathode; an anode; and an electrolytic solution, wherein the anode contains a plurality of metal fibers forming a three-dimensional network structure and a plurality of anode active material particles having silicon (Si).

### [Disclosure]

### [Technical Problem]

The present invention has been made to solve the above-described problems of the prior art, and the objective thereof is to provide an electrode for an electrochemical device with a three-dimensional network structure which is flexible and capable of realizing high capacity, a method of producing the electrode, and an electrochemical device including the electrode.

### [Technical Solution]

In order to achieve the objective, an electrode for an electrochemical device according to an embodiment of the present invention includes a network structure as defined in the claims.

Another embodiment of the present invention provides a method of producing an electrode for an electrochemical device, which includes preparing a mixed solution including a cellulose fiber, a conductive material and an active material; and filtering the mixed solution as defined in the claims.

Further, still another embodiment of the present invention provides an electrochemical device including the above-described electrode.

### [Description of Drawings]

FIG. 1 schematically shows an electrode with a three-dimensional network structure according to an embodiment of the present invention.
FIG. 2 is a micrograph showing an electrode mixture before filtration in Preparation Example 1.FIG. 3 is a result of observing an electrode of Preparation Example 1 using an electron microscope.
FIG. 4 is a photograph showing a process of a taping test for the electrode of Preparation Example 1.
FIG. 5 is a result of evaluating the bending characteristics of the electrode using a 2 mm acrylic rod.
FIG. 6 is an electron micrograph for evaluating the twisting characteristics of the electrode tied into a ribbon-like knot.
FIG. 7 is a result of evaluating the folding characteristics of the electrode folded at intervals of 5 mm.
FIG. 8 is a result of comparing and evaluating a capacity per electrode area.
FIG. 9 is a result of observing a cross section of an electrode of a battery according to Example 1.
FIG. 10 is a result of observing a cross section of an electrode of a battery according to Comparative Example 2.
FIG. 11 is a graph obtained by comparing and calculating a capacity per unit area of the electrode.
FIG. 12 is a graph comparing the cycle characteristics of batteries.
FIG. 13 is a graph comparing the discharge characteristics by rate of batteries.
FIG. 14 is a result of observing an electrode using an electron microscope at the point of repetition of charging and discharging.
FIG. 15 is a result of taking photographs of a process of producing a battery folded in a paper crane form.
FIG. 16 is a result of an experiment in which the battery folded in a paper crane form is connected with an LED lamp and whether the LED lamp worked or not is confirmed.
FIG. 17 is a result of charging/discharging experiments on the battery folded in a paper crane form.

### [Best Mode for Carrying out the Invention]

Hereinafter, an electrode with a three-dimensional network structure of the present invention will be described in detail. However, it is to be understood that the following embodiments are provided by way of illustrative purposes only, and the present invention is not limited thereto.

In the present invention, the term 'parts by weight' refers to a weight ratio between components.

In the present invention, the term 'network structure' collectively refers to a three-dimensional structure in which components are entangled with each other to form a network. Further, the term 'three-dimensional network structure' refers to a network structure which is formed by networks of components and has a certain thickness, and for example, is meant to include all of a case in which a two-dimensional network structure is stacked in a plurality of layers, a case in which a network structure itself forms a three-dimensional structure having a thickness, or a case in which a three-dimensional network structure is stacked in a plurality of layers.

In the present invention, the term 'thickness' refers to a distance in the short axis direction of a substance or particle, and the term 'length' refers to a distance in the long axis direction.

In an embodiment, an electrode for an electrochemical device according to the present invention includes a network structure including a cellulose fiber and a conductive material in which an average ratio of a length to a thickness (L/D) is 50 or more; and an active material dispersed in the network structure.

In an example, the electrode according to the present invention is formed with a network structure in which a cellulose fiber and a conductive material are entangled with each other and an active material is dispersed. More specifically, the active material is dispersed in the network structure formed of the cellulose fiber and conductive material to form a three-dimensional structure. Further, the electrode may be formed with a porous structure in which the cellulose fiber, conductive material and active material are mutually dispersed and aggregated.

The conductive material has the ratio of the length to the thickness (L/D) of 50 or more, 100 or more, or in the range of 50 to 10,000. The conductive material according to the present invention has a major axis longer than a minor axis, and a specific shape thereof is not limited as long as the conductive material can be mixed with a cellulose fiber to form a network. For example, the conductive material may be in the form of a sheet, a rod or a fiber. Specifically, the conductive material may be in the form of a fiber, and for example, in the form of a nanofiber. For example, the conductive material in nanofiber form may have a diameter in the range of 0.1 to 500 µm, 1 to 100 µm, or 50 µm or less, but is not limited thereto.

In another example, the electrode may have a multilayer structure in which structures having the active material dispersed in the network structure formed of the cellulose fiber and conductive material are stacked 2 to 10 times, 2 to 5 times, or 2 times. This is a structure formed by stacking a plurality of layers in which the active material is dispersed in the network structure formed by mixing the cellulose fiber and conductive material. When an electrode having the multilayer structure is formed, the mechanical properties and capacity of the electrode can be increased without greatly reducing the flexibility of the electrode.

The above-described components of the electrode will be described as follows.

First, the cellulose fiber is collectively referred to as a fiber-type cellulose.

As an example, the cellulose fiber may have an average diameter in the range of 10 to 1,000 nm or 50 to 500 nm. Further, an average length of the cellulose fiber may be in the range of 10 to 100,000 nm. When the diameter of the cellulose fiber is controlled within the above-described range, a fibrous phase is easily formed, the surface of the network structure prepared becomes uniform, and thereby interfacial properties can be improved.

The type of the cellulose fiber is not particularly limited, and for example, may be one or more selected from cellulose nanofibers separated from nano-sized woody materials, seaweed nanofibers, bacterial cellulose obtained by cultivating a bacterium, derivatives thereof, and mixtures thereof.

As the conductive material, for example, a conductive material having an average diameter in the range of 0.001 to 100 mm may be used. When the diameter of the conductive material is controlled within the above-described range, a fibrous phase is easily formed, the surface of the network structure prepared becomes uniform, and thereby interfacial properties can be improved.

As an example, the conductive material may include one or more selected from the group consisting of one or more carbon-based materials such as carbon fiber, graphene, carbon nanotubes, and carbon ribbons; one or more metals such as copper, nickel and aluminum; and one or more conductive polymers such as polyphenylene and polyphenylene derivatives. The carbon-based material, metal or conductive polymer may be in a fiber form. For example, the conductive material may be a carbon nanofiber.

As the active material, various components which are usable in an electrode for an electrochemical device may be applied without limitation. In an example, the active material may have an average diameter in the range of 0.001 to 30 mm, or 0.01 to 10 mm. When the range of the active material is controlled as the above-described range, the active material is easily dispersed in the network structure formed of the cellulose fiber and conductive material, and the capacity of the device can be sufficiently secured.

For example, the active material may include one or more selected from the group consisting of a lithium nickel-based oxide, a lithium cobalt-based oxide, a lithium nickel manganese-based oxide, a lithium nickel cobalt manganese-based oxide, a lithium nickel cobalt aluminum-based oxide, a lithium iron phosphate-based oxide, lithium metal, an alloy of lithium metal and a transition metal oxide. Examples of the active material include materials capable of reversibly intercalating and deintercalating lithium ions and/or materials capable of doping and dedoping lithium.

Hereinafter, a method of producing an electrode for an electrochemical device according to the present invention will be described in detail.

The electrode according to the present invention is produced by a filtering process for a mixture for producing an electrode. In an embodiment, a method of producing an electrode according to the present invention includes: preparing a mixed solution including a cellulose fiber, a conductive material in which an average ratio of a length to a thickness (L/D) is 50 or more, and an active material; and filtering the mixed solution.

In an example, the ratio of the cellulose fiber, conductive material and active material included in the mixed solution may be a weight ratio in the range of 1:2 to 5:10 to 25, 1:2.5 to 4 :12 to 20, 1:2.5 to 3.5:15 to 20, or 1:3:16. When the ratio of components included in the mixed solution is controlled as above, the three-dimensional network structure may be stably formed by mixing of the cellulose fiber and conductive material without deteriorating the dispersibility of the active material.

In the present invention, at least one process of ultrasonic treatment and ball milling on the mixed solution may be performed after preparing the mixed solution including the cellulose fiber, the conductive material and the active material. For example, the dispersibility of each component may be increased by applying ultrasonic waves, and the application of the ultrasonic waves may be carried out for 30 minutes to 2 hours.

Further, the filtering of the mixed solution is not particularly limited, but may be performed by, for example, vacuum filtration. When the mixed solution is filtered, a sheet in which the active material is dispersed in the network structure formed of the cellulose fiber and conductive material may be formed. The sheet thus prepared may be subjected to a drying process as necessary. For example, the drying process may be performed by lyophilization.

In the method of producing an electrode according to the present invention, a structure in which a plurality of layers of the three-dimensional network structure are stacked may be formed by performing the above-described processes several times and stacking each layer thus prepared. For example, a step of stacking each prepared electrode 2 to 5 times may be further performed.

In an example, the method of producing an electrode according to the present invention will be described as follows.

First, a solution in which cellulose fibers are dispersed is prepared. Here, a basic material such as sodium hydroxide (NaOH) and/or an additive such as urea may be added in order to facilitate the dispersion of the cellulose fibers.

Separately, a solution in which a mixture of a fibrous conductive material and a solvent is dispersed is prepared. Here, a dispersant such as a surfactant or a polymer-based dispersant may be added to facilitate the dispersion of the conductive material. The type of the dispersant is not particularly limited, and one or more surfactants such as sodium dodecyl sulfate (SDS), sodium dodecyl benzenesulfonate (SDBS) and cetyl trimethyl ammonium bromide (CTAB); and/or one or more polymer-based dispersants such as polybenzimidazole (PBI) and polyvinylpyrrolidone (PVP) may be selectively used or may be used in combination. As the dispersant, sodium dodecyl sulfonate or a mixture of sodium dodecyl sulfonate and urea may be used. When the mixture of sodium dodecyl sulfonate and urea is used, for example, a mixing ratio (v/v) may be in the range of 1:9 to 9:1, 2:8 to 8:2, or 4:6 to 6:4.

Next, a solution in which cellulose fibers are dispersed, a solution in which conductive materials are dispersed, and a mixed solution in which active materials are mixed are prepared. Here, a dispersant may be further added to increase the dispersibility of the mixed solution.

The mixed solution thus prepared is filtered to prepare a sheet. The sheet thus prepared is dried to produce an electrode having a three-dimensional network structure.

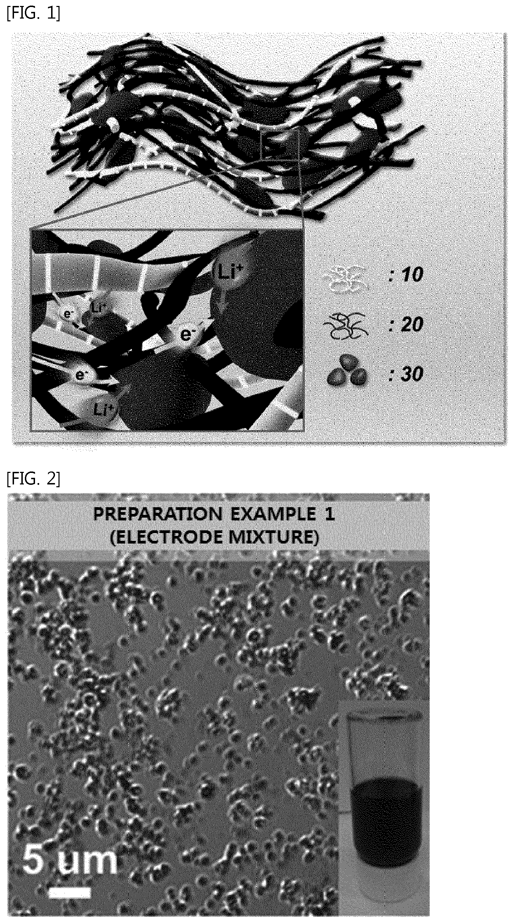

FIG. 1 is a schematic view showing an electrode with a three-dimensional network structure according to an embodiment of the present invention. Referring to FIG. 1, the electrode according to the present invention has a structure in which cellulose fibers 10 and carbon nanofibers 20 which are conductive materials in the form of fibers are entangled with each other to form a three-dimensional network structure, and active materials 30 are uniformly dispersed therebetween. The cellulose fibers 10 and carbon nanofibers 20 are physically coupled to each other to form a network, thereby forming a very stable interface in an electrode. Due to this structural characteristic, the electrode having the three-dimensional network structure can be produced without a separate binder and a metal current collector. Further, since a separate binder and metal current collector are not required in the production of the electrode, ionic conductivity and electron conductivity are excellent, and high capacity and high output characteristics can be realized when the electrode is applied to an electrochemical device.

### [Modes of the Invention]

Hereinafter, the effect of the present invention will be described in detail in conjunction with the embodiments. However, these embodiments are exemplary, and do not limit the present invention, and the present invention is defined by the scope of the claims which will be described below.

### Preparation Example 1

### 1-1. Preparation of electrode mixture

Cellulose powder (average particle size:∼45µm, KC flock, Nippon Paper Chemicals Co., Ltd.) was added to an aqueous solution of 2 wt% sodium hydroxide (NaOH), a mixture was stirred for 1 hour, and passed through a homogenizer (M-1100EH-30, Microfluidics, USA) 12 times to prepare a dispersion solution in which cellulose fibers were dispersed.

LiFePO₄ having an average particle size of 500 nm was used as a positive electrode active material, Li₄Ti₅O₁₂ having an average particle size of 300 nm was used as a negative electrode active material, and carbon nanotubes were used as a conductive material in the form of nanofibers. Sodium dodecyl sulfate (SDS) was used as a dispersant for uniform dispersion of the carbon nanotubes.

First, a solution prepared by adding 1 wt% of a dispersant to distilled water was prepared, and a positive electrode or negative electrode active material, carbon nanofibers and cellulose was added to the solution in a weight ratio of 80:15:5 to prepare each electrode mixture. Ultrasonic treatment was performed on each electrode mixture for 1 hour for a uniform dispersion effect.

### 1-2. Preparation of electrode with three-dimensional network structure

The prepared electrode mixture dispersion solution was poured onto filter paper placed on a porcelain Buchner funnel, and then subjected to filtration under reduced pressure using a vacuum pump to prepare a sheet. The sheet thus prepared was subjected to filtration under reduced pressure using ethanol and acetone alternately, followed by lyophilization under the conditions of -95 °C and 5x10⁻³ Torr and drying at 100 °C for 12 hours to remove moisture. As a result, a positive electrode and a negative electrode each having a three-dimensional network structure were produced.

### Preparation Examples 2 to 7

An electrode was produced in the same manner as in Example 1 except that the contents of the electrode active material, the conductive material and the cellulose fiber were varied as shown in the following Table 1. The units shown in the following Table 1 are parts by weight.

| No. | Electrode active material | Conductive material | Cellulose fiber |
|---|---|---|---|
| Preparation Example 2 | 75 | 18 | 7 |
| Preparation Example 3 | 78 | 15 | 7 |
| Preparation Example 4 | 78 | 17 | 5 |
| Preparation Example 5 | 82 | 13 | 7 |
| Preparation Example 6 | 82 | 15 | 3 |
| Preparation Example 7 | 85 | 10 | 5 |

### Preparation Example 8

An electrode was produced in the same manner as in Preparation Example 1 except that sodium dodecyl benzenesulfonate (SDBS) was used instead of sodium dodecyl sulfate (SDS) as a dispersant for uniform dispersion of carbon nanotubes.

### Preparation Example 9

An electrode was produced in the same manner as in Preparation Example 1 except that sodium dodecyl sulfate (SDS) and urea were used together in a volume ratio of 1:1 as a dispersant for uniform dispersion of carbon nanotubes.

### Comparative Preparation Example 1

An electrode was produced in the same manner as in Preparation Example 1 except that cellulose fibers were not added.

### Comparative Preparation Example 2

The same material as in Example 1 was used as the electrode active material, carbon black was used as a conductive material, and polyvinylidene fluoride (PVDF) was used as a binder. The mixture thereof was added to N-methyl-2-pyrrolidone (NMP), which is a solvent, to prepare an electrode slurry. Here, the composition of the solid contents of the positive electrode and negative electrode slurries was set such that the weight ratio of the positive electrode active material, the conductive material and the binder is 80:10:10 and the weight ratio of negative electrode active material, the conductive material and the binder is 88:2:10. The electrode slurry thus prepared was applied onto an aluminum having a thickness of 21 µm and dried, followed by roll pressing to produce an electrode.

### Experimental Example 1: Evaluation of dispersibility of electrode mixture solution

The dispersion degree of the electrode mixture before filtration in Preparation Example 1 was observed by microscopic analysis. Congo Red dye was added to dye the cellulose fibers in red to facilitate the analysis by the microscope.

The observation results are shown in FIG. 2. Referring to FIG. 2, it can be seen that an electrode mixture solution in which the active materials, cellulose fibers and carbon nanotubes are dispersed is prepared. Although no separate drawing was disclosed, it was confirmed that the dispersibility of the electrode mixture solution according to Preparation Example 9 was the most excellent in terms of dispersibility.

### Experimental Example 2: Observation of produced electrode using electron microscope

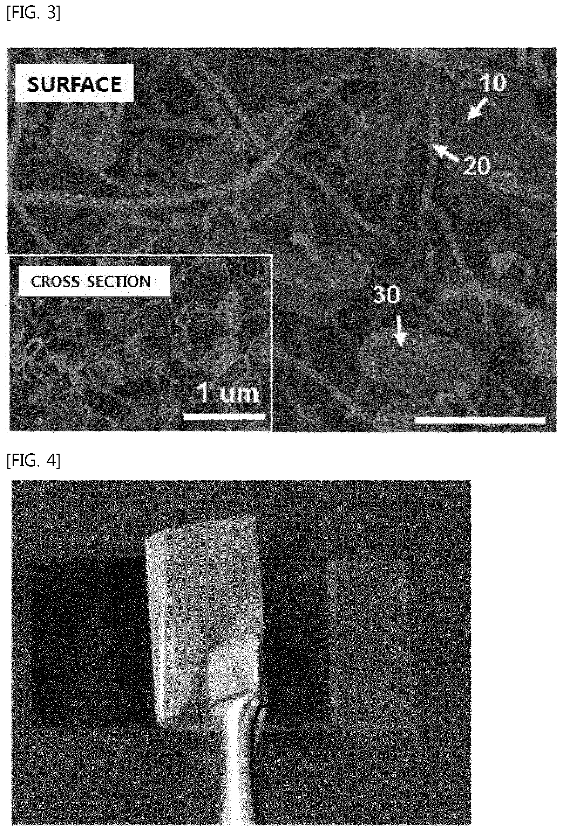

The electrode produced in Preparation Example 1 was observed using an electron microscope. The observation results are shown in FIG. 3.

Referring to FIG. 3, it can be seen that the cellulose fibers 10 and the carbon nanotubes 20 are entangled with each other in the electrode to form a three dimensional network structure and the active materials 30 are dispersed between the formed network structures. Further, it can be seen from the cross-sectional photograph shown at the bottom-left of FIG. 3 that the electrode according to the present invention formed a three-dimensional network structure.

### Experimental Example 3: Taping test on electrode

In order to evaluate the adhesiveness of the electrode produced according to Preparation Example 1, a taping test was performed in the manner as shown in FIG. 4.

Referring to FIG. 4, it can be seen that the surface of the electrode where the tape is removed is smooth and there is no part where the electrode is separated. That is, it was confirmed that the electrode according to Preparation Example 1 showed a stable interface even during the taping test because the interface was formed very stably. As a result, it was confirmed that the electrode having a three-dimensional network structure based on cellulose fibers and carbon nanofibers according to the present invention can secure excellent mechanical properties without using a separate binder or current collector.

### Experimental Example 4: Evaluation of flexibility of electrode

Bending, twisting, and folding characteristics were evaluated to evaluate the flexibility of the electrode produced in Preparation Example 1.

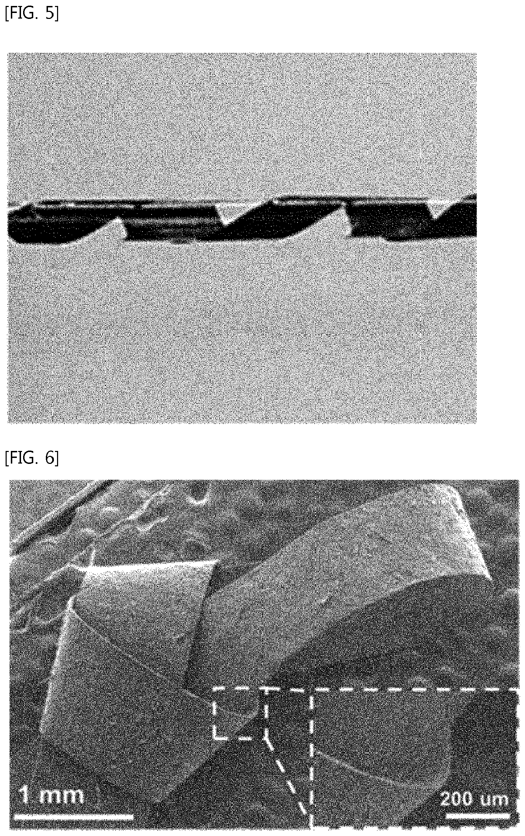

The bending characteristics were evaluated by winding the electrode on a 2 mm acrylic bar. The evaluation process is shown in FIG. 5.

The twisting characteristics were observed by scanning electron microscopy (SEM) after the electrode was tied into a ribbon-like knot. The observation results are shown in FIG. 6.

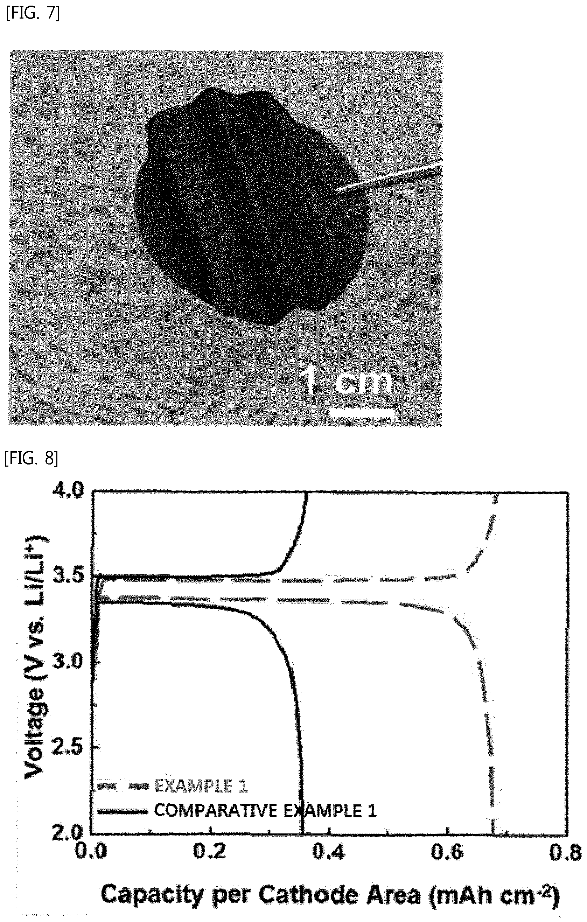

The folding characteristics were evaluated after the electrode was folded at intervals of 5 mm. The evaluation process is shown in FIG. 7.

First, referring to FIG. 5, it can be seen that the produced electrode has excellent flexibility and is not broken or cracked when it is wound on a rod having a diameter of 2 mm.

Referring to FIG. 6, it can be confirmed that the produced electrode shows excellent mechanical properties to the extent that a ribbon-like knot can be formed using the produced electrode.

Referring to FIG. 7, the produced electrode showed mechanical properties to the extent that the electrode could be folded at intervals of 5 mm.

As confirmed from FIGS. 5 to 7, it can be seen that the electrode according to the present invention can secure excellent mechanical properties even though it is produced without a separate binder or current collector.

### Example 1: Production of electrochemical device-Production of coin cell

Each battery was produced by sequentially stacking a positive electrode/cellulose-based separator and a negative electrode using the electrodes produced in Preparation Example 1 and injecting a liquid electrolyte (1M LiPF₆ in EC/DEC (1/1 v/v)).

### Examples 2 to 7: Production of electrochemical device-Production of coin cell

Each battery was produced by sequentially stacking a positive electrode/cellulose-based separator and a negative electrode using the electrodes produced in Preparation Examples 2 to 7 and injecting a liquid electrolyte (1M LiPF₆ in EC/DEC (1/1 v/v)).

### Comparative Example 1

Each battery was produced by sequentially stacking a positive electrode/cellulose-based separator and a negative electrode using the electrodes produced in Comparative Preparation Example 1 and injecting a liquid electrolyte (1M LiPF₆ in EC/DEC (1/1 v/v)).

### Comparative Example 2

A battery was produced using the electrodes produced in Comparative Preparation Example 2, a polyethylene separator which is a polyolefin-based separator, and a liquid electrolyte (1M LiPF₆ in EC/DEC (1/1 v/v)).

### Experimental Example 5: Evaluation of capacity per unit area

The capacity per unit area of electrode of each battery produced in Example 1 and Comparative Example 2 was evaluated. The evaluation results are shown in FIG. 8.

Referring to FIG. 8, it can be seen that the battery of Example 1 is significantly superior in capacity per unit area as compared with the battery of Comparative Example 2.

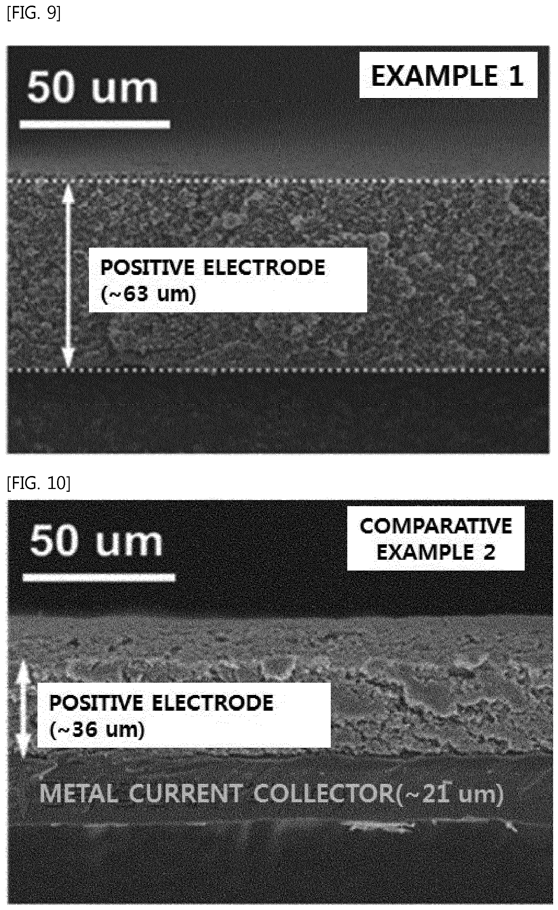

Further, each of the cross-sectional structures of the electrodes produced in Example 1 and Comparative Example 2 were compared and observed. The results of observing the cross sections of the electrodes produced in Example 1 and Comparative Example 2 are shown in FIGS. 9 and 10, respectively.

First, referring to FIG. 9, it can be seen that the electrode having a three-dimensional network structure with a thickness of 63 µm is sufficiently formed in the battery of Example 1. On the other hand, referring to FIG. 10, the battery of Comparative Example 2 has a structure in which a positive electrode material having a thickness of 36 µm and a metal current collector having a thickness of 21 µm are stacked.

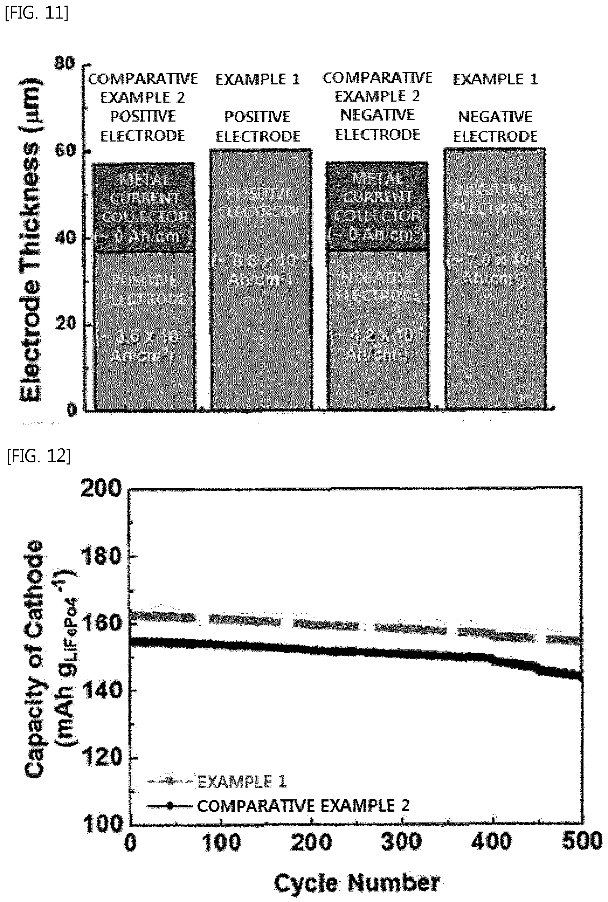

The capacity per unit area of each of the positive electrode and the negative electrode of the battery according to Example 1 and Comparative Example 2 was calculated and shown in FIG. 11.

Referring to FIG. 11, since the positive electrode and the negative electrode of Example 1 do not require a separate metal current collector, remarkably excellent capacity per unit area is realized.

### Experimental Example 6: Evaluation of physical properties of batteries

In order to evaluate the performance of each of the batteries produced in Example 1 and Comparative Example 2, cycle characteristics and discharge characteristics by rate were observed.

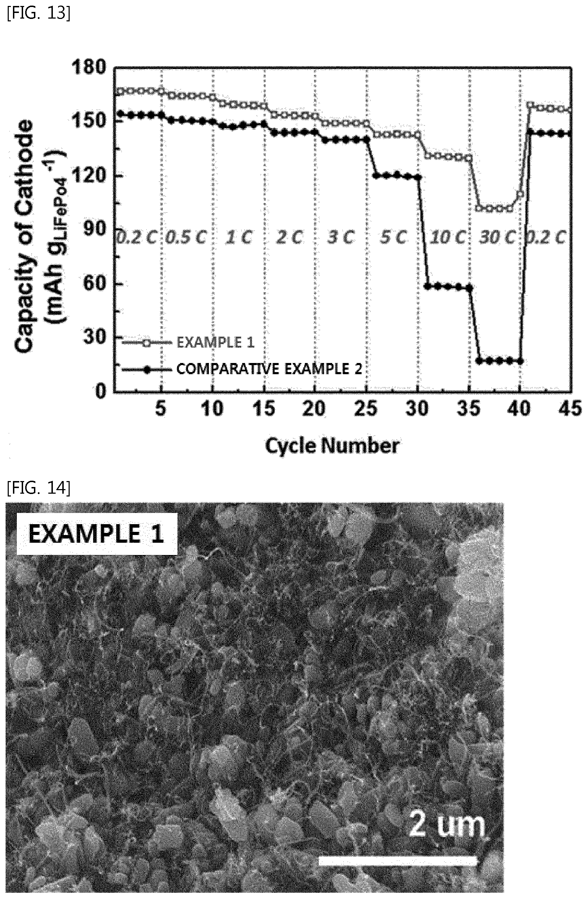

Specifically, cycle characteristics were evaluated by charging/discharging the batteries at a constant current rate of 1.0 C for 500 cycles. The results are shown in FIG. 12. Further, the discharge capacity of the battery was evaluated by discharging the battery at a current rate of 0.2 to 30 C under a constant charge current of 0.2 C for evaluation of discharge characteristics by rate. The results are shown in FIG. 13.

Referring to FIGS. 12 and 13, it can be confirmed that the battery according to Example 1 has excellent interfacial stability in the electrode and no separate binder is used, and thus the cycle characteristics and the discharge characteristics by rate are remarkably superior to those of Comparative Example 2 due to the improvement of ionic conductivity/electronic conductivity.

Further, the electrodes were observed using an electron microscope after 500 cycles of charging/discharging were performed in order to confirm whether the structure of the electrode was maintained even after repetition of charging/discharging. The observation results are shown in FIG. 14.

Referring to FIG. 14, it can be seen that the three-dimensional network structure of the electrode of the battery according to Example 1 was maintained even after 500 cycles of charging/discharging.

### Experimental Example 7: Evaluation of folding characteristics of battery

The folding characteristics of the battery of Example 1 were evaluated. Specifically, the battery was connected to an LED lamp in a state of being folded in a paper crane form using a paper folding method, and whether the electrode worked or not was confirmed. Further, the charge/discharge experiment was conducted at a constant current rate of 0.2 C for the produced battery to confirm a change in capacity.

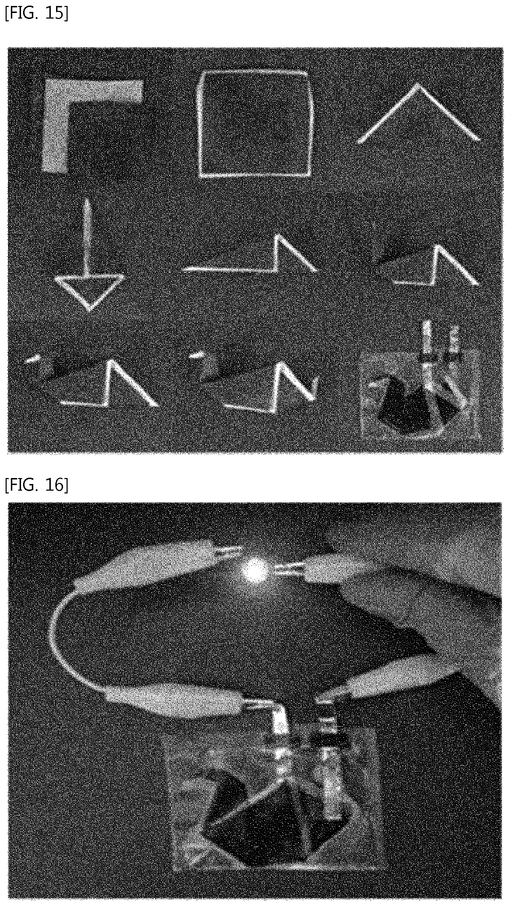

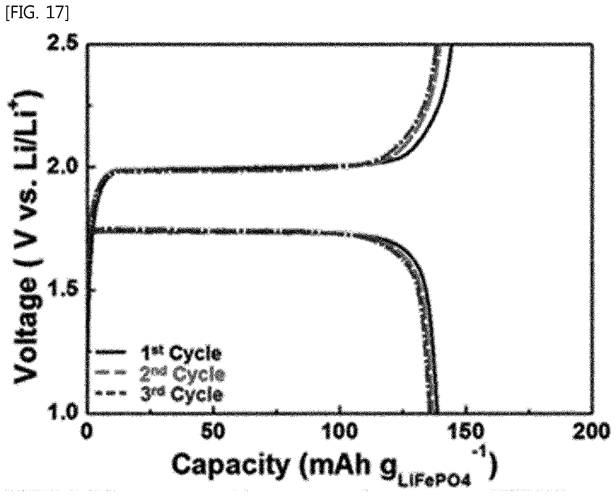

FIG. 15 is a result of taking photographs of a process of producing a battery folded in a paper crane form, and FIG. 16 is a result of an experiment in which the battery folded in a paper crane form is connected with an LED lamp and whether the LED lamp worked or not is confirmed. Further, FIG. 17 shows a result of performing 3 charging/discharging experiments on the battery thus prepared at a constant current rate of 0.2 C.

It is confirmed from the results of FIGS. 15 to 17 that the battery according to the present invention is flexible and has characteristics capable of being folded in a paper crane form. Further, it was confirmed that the electrode of the present invention exhibited excellent folding characteristics from the LED lamp being operated by the battery folded in a paper crane form.

### [Descriptions for reference number]

10: CELLULOSE FIBER
20: CARBON NANOTUBE
30: ACTIVE MATERIAL

### [Industrial Applicability]

The electrode according to the present invention enables a simple production process, has a stable interface in the electrode, and can provide a flexible electrochemical device with high capacity.

## Claims

1. An electrode for an electrochemical device, comprising:
a network structure including cellulose fibers and a conductive material; and
an active material dispersed in the network structure,
wherein the conductive material particles have an average ratio of a length to a thickness(L/D) of 50 or more,
wherein, in the electrode for an electrochemical device, the active material is dispersed in the network structure formed of the cellulose fibers and conductive material to form a three-dimensional structure.

2. The electrode according to claim 1, wherein the electrode for an electrochemical device is formed with a porous structure in which the cellulose fibers, conductive material and active material are dispersed.

3. The electrode according to claim 1, wherein the electrode has a multilayer structure in which structures having the active material dispersed in the network structure formed of the cellulose fibers and conductive material are stacked 2 to 10 times.

4. The electrode according to claim 1, wherein a content of the active material is in a range of 50 to 95 parts by weight based on 100 parts by weight of the total weight of the electrode.

5. The electrode according to claim 1, wherein a content ratio of the cellulose fibers to the conductive material is a weight ratio of 1:2 to 1:5.

6. The electrode according to claim 1, wherein an average diameter of the cellulose fibers is in a range of 10 to 1,000 nm.

7. The electrode according to claim 1, wherein the conductive material is in the form of nanofibers, and the conductive material in the form of the nanofibers has an average diameter in a range of 0.001 to 100 µm.

8. The electrode according to claim 1, wherein the conductive material includes one or more selected from the group consisting of one or more carbon-based materials such as carbon fibers, graphene, carbon nanotubes, and carbon ribbons; one or more metals such as copper, nickel and aluminum; and one or more conductive polymers such as polyphenylene and polyphenylene derivatives.

9. A method of producing an electrode for an electrochemical device, comprising:
preparing a mixed solution including cellulose fibers, a conductive material wherein the conductive material particles have an average ratio of a length to a thickness(L/D) of 50 or more, and an active material;
filtering the mixed solution to form a sheet in which the active material is dispersed in the network structure formed of the cellulose fibers and conductive material to form a three-dimensional structure.

10. The method according to claim 9, wherein a ratio of the cellulose fibers, conductive material and active material included in the mixed solution is a weight ratio of 1:2 to 5:10 to 25.

11. The method according to claim 9, further comprising performing one or more processes of ultrasonic treatment and ball milling on the mixed solution after preparing the mixed solution including the cellulose fibers, the conductive material and the active material.

12. The method according to claim 9, wherein filtering of the mixed solution is performed by vacuum filtration.

13. The method according to claim 9, further comprising stacking the produced electrode 2 to 5 times.

14. An electrochemical device comprising the electrode according to claim 1.

15. The electrochemical device according to claim 14, comprising a cellulose separator as a separator interposed between a first electrode and a second electrode.

16. The electrochemical device according to claim 14, wherein the electrochemical device is a flexible device.

17. The electrochemical device according to claim 14, wherein the electrochemical device is a secondary battery, a capacitor, or a solar battery.

## Patentansprüche

1. Elektrode für eine elektrochemische Vorrichtung, umfassend:
eine Netzwerkstruktur, die Cellulosefasern und ein leitfähiges Material enthält; und
ein in der Netzwerkstruktur verteiltes aktives Material,
wobei die Partikel des leitfähigen Materials ein durchschnittliches Verhältnis von Länge zu Dicke (L/D) von 50 oder mehr aufweisen,
wobei das aktive Material in der Elektrode für eine elektrochemische Vorrichtung in der Netzwerkstruktur verteilt ist, die aus den Cellulosefasern und dem leitfähigen Material geformt ist, um eine dreidimensionale Struktur zu bilden.

2. Elektrode nach Anspruch 1, wobei die Elektrode für eine elektrochemische Vorrichtung mit einer porösen Struktur ausgebildet ist, in der die Cellulosefasern, das leitfähige Material und das aktive Material verteilt sind.

3. Elektrode nach Anspruch 1, wobei die Elektrode eine Mehrschichtstruktur aufweist, in der Strukturen mit dem aktiven Material, das in der aus Cellulosefasern und dem leitfähigen Material gebildeten Netzwerkstruktur verteilt ist, 2- bis 10-mal geschichtet sind.

4. Elektrode nach Anspruch 1, wobei ein Gehalt des aktiven Materials in einem Bereich von 50 bis 95 Gewichtsteilen liegt, bezogen auf 100 Gewichtsteile des Gesamtgewichts der Elektrode.

5. Elektrode nach Anspruch 1, wobei ein Gehaltsverhältnis der Cellulosefasern zu dem leitfähigen Material ein Gewichtsverhältnis von 1:2 bis 1:5 ist.

6. Elektrode nach Anspruch 1, wobei ein durchschnittlicher Durchmesser der Cellulosefasern in einem Bereich von 10 bis 1000 nm liegt.

7. Elektrode nach Anspruch 1, wobei das leitfähige Material in der Form von Nanofasern vorliegt und das leitfähige Material in der Form von Nanofasern einen durchschnittlichen Durchmesser in einem Bereich von 0,001 bis 100 µm aufweist.

8. Elektrode nach Anspruch 1, wobei das leitfähige Material eines oder mehrere ausgewählt aus der Gruppe, die aus einem oder mehreren Materialien auf Kohlenstoffbasis wie Kohlefasern, Graphen, Kohlenstoff-Nanoröhrchen und Karbonbändern besteht; eines oder mehrere Metalle wie Kupfer, Nickel und Aluminium; und ein oder mehrere leitfähige Polymere wie Polyphenylen und Polyphenylenderivate umfasst.

9. Verfahren zum Herstellen einer Elektrode für eine elektrochemische Vorrichtung, umfassend:
Herstellen einer gemischten Lösung, die Cellulosefasern, ein leitfähiges Material, wobei die Partikel des leitfähigen Materials ein durchschnittliches Verhältnis von Länge zu Dicke (L/D) von 50 oder mehr aufweisen, und ein aktives Material enthält;
Filtrieren der gemischten Lösung um eine Folie zu bilden, in der das aktive Material in der Netzwerkstruktur verteilt ist, die aus den Cellulosefasern und dem leitfähigen Material geformt ist, um eine dreidimensionale Struktur zu bilden.

10. Verfahren nach Anspruch 9, wobei ein Verhältnis der in der gemischten Lösung enthaltenen Cellulosefasern, des leitfähigen Materials und des aktiven Materials ein Gewichtsverhältnis von 1:2 zu 5:10 zu 25 ist.

11. Verfahren nach Anspruch 9, ferner umfassend das Durchführen eines oder mehrerer Verfahren der Ultraschallbehandlung und des Kugelmahlens an der gemischten Lösung nach dem Herstellen der gemischten Lösung, die die Cellulosefasern, das leitfähige Material und das aktive Material enthält.

12. Verfahren nach Anspruch 9, wobei das Filtrieren der gemischten Lösung durch Vakuumfiltration durchgeführt wird.

13. Verfahren nach Anspruch 9, ferner umfassend das 2- bis 5-fache Stapeln der hergestellten Elektrode.

14. Elektrochemische Vorrichtung, umfassend die Elektrode nach Anspruch 1.

15. Elektrochemische Vorrichtung nach Anspruch 14, umfassend einen Cellulose-Separator als Separator, der zwischen einer ersten Elektrode und einer zweiten Elektrode eingefügt ist.

16. Elektrochemische Vorrichtung nach Anspruch 14, wobei die elektrochemische Vorrichtung eine flexible Vorrichtung ist.

17. Elektrochemische Vorrichtung nach Anspruch 14, wobei die elektrochemische Vorrichtung eine Sekundärbatterie, ein Kondensator oder eine Solarbatterie ist.

## Revendications

1. Electrode pour un dispositif électrochimique, comprenant :
une structure de réseau comportant des fibres de cellulose et un matériau conducteur ; et
un matériau actif dispersé dans la structure de réseau,
dans laquelle les particules de matériau conducteur ont un rapport moyen entre une longueur et une épaisseur (L/D) de 50 ou plus,
dans laquelle, dans l'électrode pour un dispositif électrochimique, le matériau actif est dispersé dans la structure de réseau formée des fibres de cellulose et du matériau conducteur pour former une structure tridimensionnelle.

2. Electrode selon la revendication 1, dans laquelle l'électrode pour un dispositif électrochimique est formée avec une structure poreuse dans laquelle les fibres de cellulose, le matériau conducteur et le matériau actif sont dispersés.

3. Electrode selon la revendication 1, dans laquelle l'électrode a une structure multicouche dans laquelle des structures ayant le matériau actif dispersé dans la structure de réseau formée des fibres de cellulose et du matériau conducteur sont empilées 2 à 10 fois.

4. Electrode selon la revendication 1, dans laquelle une teneur du matériau actif est dans une plage de 50 à 95 parties en poids sur la base de 100 parties en poids du poids total de l'électrode.

5. Electrode selon la revendication 1, dans laquelle un rapport de teneur entre les fibres de cellulose et le matériau conducteur est un rapport en poids de 1 : 2 à 1 : 5.

6. Electrode selon la revendication 1, dans laquelle un diamètre moyen des fibres de cellulose est dans une plage de 10 à 1000 nm.

7. Electrode selon la revendication 1, dans laquelle le matériau conducteur se présente sous la forme de nanofibres, et le matériau conducteur sous la forme de nanofibres a un diamètre moyen dans une plage de 0,001 à 100 µm.

8. Electrode selon la revendication 1, dans laquelle le matériau conducteur comporte un ou plusieurs éléments sélectionnés dans le groupe constitué d'un ou de plusieurs matériaux à base de carbone tels que des fibres de carbone, le graphène, des nanotubes de carbone, et des rubans de carbone ; d'un ou de plusieurs métaux tels que le cuivre, le nickel et l'aluminium ; et d'un ou de plusieurs polymères conducteurs tels que le polyphénylène et des dérivés de polyphénylène.

9. Procédé de production d'une électrode pour un dispositif électrochimique, comprenant :
la préparation d'une solution mixte comportant des fibres de cellulose, un matériau conducteur, dans lequel les particules de matériau conducteur ont un rapport moyen entre une longueur et une épaisseur (L/D) de 50 ou plus, et un matériau actif ;
la filtration de la solution mixte pour former une feuille dans laquelle le matériau actif est dispersé dans la structure de réseau formée des fibres de cellulose et du matériau conducteur pour former une structure tridimensionnelle.

10. Procédé selon la revendication 9, dans lequel un rapport entre les fibres de cellulose, le matériau conducteur et le matériau actif compris dans la solution mixte est un rapport en poids de 1 : 2 à 5 : 10 à 25.

11. Procédé selon la revendication 9, comprenant en outre la réalisation d'un ou de plusieurs processus de traitement par ultrasons et de broyage à boulets sur la solution mixte après la préparation de la solution mixte comportant les fibres de cellulose, le matériau conducteur et le matériau actif.

12. Procédé selon la revendication 9, dans lequel la filtration de la solution mixte est réalisée par filtration sous vide.

13. Procédé selon la revendication 9, comprenant en outre l'empilement de l'électrode produite 2 à 5 fois.

14. Dispositif électrochimique comprenant l'électrode selon la revendication 1.

15. Dispositif électrochimique selon la revendication 14, comprenant un séparateur de cellulose sous la forme d'un séparateur interposé entre une première électrode et une seconde électrode.

16. Dispositif électrochimique selon la revendication 14, dans lequel le dispositif électrochimique est un dispositif souple.

17. Dispositif électrochimique selon la revendication 14, dans lequel le dispositif électrochimique est une batterie secondaire, un condensateur, ou une batterie solaire.
